# EUROPEAN PATENT APPLICATION

(11) **EP 4 613 542 A1**
(43) Date of publication of application: **10.09.2025**
(21) Application number: 23887458.0
(22) Date of filing: 19.06.2023
(51) Int. Cl.: B60L 53/302

(54) **CHARGING DEVICE AND CHARGING SYSTEM**

(30) Priority: 07.11.2022 CN 202211383168
(71) Applicant: Huawei Digital Power Technologies Co., Ltd., Shenzhen, Guangdong 518043 (CN)
(72) Inventor: WEI, Longhe, Shenzhen, Guangdong 518043 (CN); GAO, Qiang, Shenzhen, Guangdong 518043 (CN)
(74) Representative: Maiwald GmbH
(86) International application number: PCT/CN2023/101066
(87) International publication number: WO 2024/098761

(57) **Abstract**

This application provides a charging device and a charging system, and relates to the field of energy technologies, to resolve a technical problem of poor heat dissipation effect for the charging device. The charging device provided in this application includes an elastic heat conducting member and at least two stacked power assemblies. The power assembly includes a housing, a liquid cooling plate, and a circuit board assembly. The housing and the liquid cooling plate form an accommodating cavity. The circuit board assembly is disposed in the accommodating cavity and is connected to the housing and the liquid cooling plate in a thermally conductive manner. A liquid cooling plate of each power assembly has a first contact surface, and a housing has a second contact surface. In two adjacent power assemblies, a first contact surface of one of the power assemblies and a second contact surface of the other one of the power assemblies are disposed opposite to each other, and the elastic heat conducting member is located between the first contact surface and the second contact surface, and elastically abuts against the first contact surface and the second contact surface. By using the elastic heat conducting member, heat dissipation structures of the two adjacent power assemblies can depend on each other, to help improve heat dissipation performance of the charging device.

## Description

### CROSS-REFERENCE TO RELATED APPLICATIONS

This application claims priority to Chinese Patent Application No. 202211383168.6, filed with the China National Intellectual Property Administration on November 7, 2022, and entitled "CHARGING DEVICE AND CHARGING SYSTEM", which is incorporated herein by reference in its entirety.

### TECHNICAL FIELD

This application relates to the field of energy technologies, and in particular, to a charging device and a charging system.

### BACKGROUND

Due to widespread popularity of electric vehicles, there is an increasing demand for charging devices (for example, a charging pile) in the industry. The charging device usually includes a plurality of different types of electrical elements. Some electronic elements generate a large amount of heat during operation. To ensure that the charging device operates within a normal operating temperature range, heat usually needs to be dissipated for some electronic components in the charging device. Currently, heat is usually dissipated for an electronic component in an air cooling manner. In the air cooling manner, a fan is usually used to generate an airflow, and the airflow quickly passes through a surface of a component that generates heat, to take away heat. However, in this manner, impurities such as dust easily accumulate on the surface of the electronic component, which affects reliability and a service life of the electronic component. In addition, the fan generates loud noise when running at a high speed, which affects charging experience of a user.

### SUMMARY

This application provides a charging device and a charging system having a simple structure and good heat dissipation efficiency.

According to a first aspect, this application provides a charging device that includes an elastic heat conducting member and at least two stacked power assemblies. The power assembly includes a housing, a liquid cooling plate, and a circuit board assembly. The housing and the liquid cooling plate form an accommodating cavity. The circuit board assembly is disposed in the accommodating cavity and is connected to both the housing and the liquid cooling plate in a thermally conductive manner. A liquid cooling plate of each power assembly has a first contact surface, and a housing has a second contact surface. The first contact surface is away from the second contact surface. In two adjacent power assemblies, a first contact surface of one of the power assemblies and a second contact surface of the other one of the power assemblies are disposed opposite to each other, and the elastic heat conducting member is located between the first contact surface and the second contact surface, and separately elastically abuts against the first contact surface and the second contact surface.

In the charging device provided in this application, the liquid cooling plate is used in the power assembly for heat dissipation, and the housing and the liquid cooling plate can enclose space for accommodating the circuit board assembly. This can improve sealing performance of the circuit board assembly, and prevents external impurities such as dust and water vapor from affecting the circuit board assembly, thereby improving operating safety and reliability of the charging device. In addition, the elastic heat conducting member is in contact with the power assembly in a thermally conductive manner, so that heat of the power assembly can be dissipated through the elastic heat conducting member, thereby improving heat dissipation performance for the power assembly. Because heat dissipation performance of the liquid cooling plate is usually greater than heat dissipation performance of the housing, in the two adjacent power assemblies, heat of a housing of one of the power assemblies can be transferred to a liquid cooling plate of the other one of the power assemblies through the elastic heat conducting member, thereby helping improve overall heat dissipation performance of the charging device.

During specific disposition, the circuit board assembly may include a circuit board and an electronic component disposed on the circuit board. The circuit board includes a first board surface and a second board surface that are away from each other. The electronic component is located on the first board surface.

During specific disposition, the electronic component may be connected to the liquid cooling plate in a thermally conductive manner, so that the liquid cooling plate can efficiently dissipate heat for the electronic component. The second board surface may be connected to the housing in a thermally conductive manner.

In an example, the elastic heat conducting member may be a wave-shaped sheet. The elastic heat conducting member features a simple structure, easy manufacturing, and good elasticity.

In addition, a first air duct exists between the elastic heat conducting member and the first contact surface, and a second air duct exists between the elastic heat conducting member and the first contact surface. Air flowing through the first air duct and the second air duct can quickly take away heat of the first contact surface, the second contact surface, and the elastic heat conducting member, thereby helping improve heat dissipation performance of the charging device.

In an example, a surface, facing the first contact surface, of the elastic heat conducting member has at least one third contact part that abuts against the first contact surface, and the third contact part may be a plane, thereby helping increase a contact area between the first contact surface and the elastic heat conducting member.

In an example, a surface, facing the second contact surface, of the elastic heat conducting member has at least one fourth contact part that abuts against the second contact surface, and the fourth contact part is a plane, thereby helping increase a contact area between the second contact surface and the elastic heat conducting member.

In an example, a material of the elastic heat conducting member includes a shape memory alloy. The elastic heat conducting member is configured to: when a temperature rises, tend to increase a contact area with the first contact surface or the second contact surface. In this way, when a temperature of the first contact surface is high, the contact area between the elastic heat conducting member and the first contact surface or the second contact surface can be increased, thereby helping improve heat dissipation effect for the housing.

In an example, the charging device may further include a chassis. The power assemblies are installed in the chassis. The elastic heat conducting member is detachably installed in the chassis. This has high use flexibility.

In an example, the elastic heat conducting member is fastened to the housing or the liquid cooling plate, to improve assembly convenience of the charging device.

In an example, the charging device includes a tray. The elastic heat conducting member is fastened to the tray. The power assemblies may be fastened in the chassis by using the tray, and may be in contact with the heat conducting member in a thermally conductive manner, thereby effectively improving assembly convenience.

In an example, the charging device may further include a radiator. The radiator is connected to the liquid cooling plate through a liquid cooling pipeline, and is configured to dissipate heat for the liquid cooling plate.

According to a second aspect, this application further provides a charging system, including a charging terminal and any foregoing charging device. The charging device has an output port. The charging terminal is connected to the output port. Electric energy processed by the charging device may be provided to the charging terminal, to supplement the electric energy to a powered device (for example, a vehicle).

During specific disposition, the charging device may be installed on the ground, or may be installed at a position such as a wall. A specific installation position and a form of the charging device are not limited in this application.

### BRIEF DESCRIPTION OF DRAWINGS

FIG. 1 is a diagram of an application scenario of a charging device according to an embodiment of this application;
FIG. 2 is a sectional view of a structure of a charging device according to an embodiment of this application;
FIG. 3 is a diagram of a side structure of an elastic heat conducting member according to an embodiment of this application;
FIG. 4 is a sectional view of a partial structure of a charging device according to an embodiment of this application;
FIG. 5 is a sectional view of another partial structure of a charging device according to an embodiment of this application;
FIG. 6 is a sectional view of another structure of a charging device according to an embodiment of this application;
FIG. 7 is a sectional view of another partial structure of a charging device according to an embodiment of this application;
FIG. 8 is a sectional view of another partial structure of a charging device according to an embodiment of this application; and
FIG. 9 is a simple diagram of a structure of a charging system according to an embodiment of this application.

### DESCRIPTION OF EMBODIMENTS

To make the objectives, technical solutions, and advantages of this application clearer, the following further describes this application in detail with reference to the accompanying drawings.

To facilitate understanding of a charging device provided in embodiments of this application, the following first describes an application scenario of the charging device.

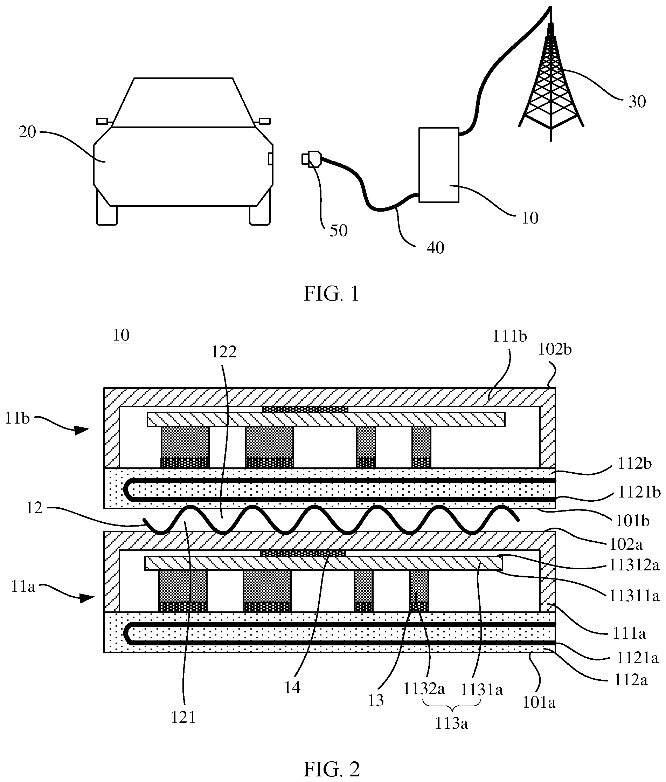

As shown in FIG. 1, in an example provided in this application, a charging device 10 may be used in a scenario of charging an electric vehicle 20. Specifically, the charging device 10 may be specifically a charging pile, and the charging device 10 may be installed near a parking space. In actual application, an input end of the charging device 10 may be connected to a power grid 30, and an output end of the charging device 10 may be connected to a charging connector 50 through a cable 40, to charge the vehicle 20. Electric energy in the power grid 30 may be industrial electricity (for example, an alternating current voltage is 380 V), or may be residential electricity (for example, an alternating current voltage is 22 V).

In actual application, the charging device 10 may have functions such as overload protection and power conversion. The charging device 10 usually includes electronic components such as a transistor, a transformer, an inductor, a capacitor, or a relay. Some electronic components generate heat during normal operation. To ensure that the charging device 10 operates within a normal operating temperature range, heat needs to be dissipated for the electronic components.

In a current charging device, heat is usually dissipated for the charging device in an air cooling manner. In the charging device using the air cooling manner, a fan is usually used to generate an airflow, and the airflow quickly passes through a surface of an electronic component to take away heat. However, in this manner, impurities such as dust easily accumulate on the surface of the electronic component, which affects reliability and a service life of the electronic component. In addition, the fan generates loud noise when running at a high speed, which affects charging experience of a user.

In view of this, embodiments of this application provide a charging device 10 that has a simple structure and low costs and can implement a relatively high level of protection, and a charging system in which the charging device 10 is used.

To make objectives, technical solutions, and advantages of this application clearer, the following further describes this application in detail with reference to the accompanying drawings and specific embodiments.

As shown in FIG. 2, in an example provided in this application, the charging device 10 may include a first power assembly 11a, a second power assembly 11b, and an elastic heat conducting member 12. The elastic heat conducting member 12 is located between the first power assembly 11a and the second power assembly 11b, and is in contact with the first power assembly 11a and the second power assembly 11b in a thermally conductive manner. In some cases, heat of the first power assembly 11a may be dissipated by using the elastic heat conducting member 12 and the second power assembly 11b, to improve heat dissipation efficiency of the charging device 10. Correspondingly, in some cases, heat of the second power assembly 11b may be dissipated by using the elastic heat conducting member 12 and the first power assembly 11a, to improve heat dissipation efficiency of the charging device 10. In summary, the elastic heat conducting member 12 can effectively dissipate the heat generated by the first power assembly 11a and the heat generated by the second power assembly 11b, and can further implement heat transfer between the first power assembly 11a and the second power assembly 11b, to effectively improve heat dissipation performance of the charging device 10.

In addition, in the example provided in this application, the first power assembly 11a and the second power assembly 11b both adopt a liquid cooling heat dissipation manner that has advantages such as high heat dissipation efficiency, good reliability, and low noise. This helps ensure sealing performance of an electronic component, thereby improving operating stability and a service life of the charging device 10.

Specifically, the first power assembly 11a includes a first housing 111a, a first liquid cooling plate 112a, and a first circuit board assembly 113a. The first housing 111a and the first liquid cooling plate 112a form an accommodating cavity (not shown in the figure). The first circuit board assembly 113a is disposed in the accommodating cavity, and is connected to the first housing 111a and the first liquid cooling plate 112a in a thermally conductive manner. The first liquid cooling plate 112a has a pipeline 1121a. A cooling medium may flow in the pipeline 1121a, to take away heat of the first liquid cooling plate 112a. The second power assembly 11b includes a second housing 111b, a second liquid cooling plate 112b, and a second circuit board assembly 113b. The second housing 111b and the second liquid cooling plate 112b form an accommodating cavity (not shown in the figure). The second circuit board assembly 113b is disposed in the accommodating cavity, and is connected to the second housing 111b and the second liquid cooling plate 112b in a thermally conductive manner. The second liquid cooling plate 112b has a pipeline 1121b. A cooling medium may flow in the pipeline 1121b, to take away heat of the second liquid cooling plate 112b.

In the example provided in this application, structures of the first power assembly 11a and the second power assembly 11b are basically the same. The following uses the first power assembly 11a as an example for specific description.

The first circuit board assembly 113a is located in space enclosed by the first housing 111a and the first liquid cooling plate 112a, thereby helping ensure sealing performance of the first circuit board assembly 113a and preventing external impurities such as dust and water vapor from corroding the first circuit board assembly 113a.

In addition, the first circuit board assembly 113a is connected to the first liquid cooling plate 112a and the first housing 111a in a thermally conductive manner. Heat generated by the first circuit board assembly 113a can be dissipated by using the first liquid cooling plate 112a and the first housing 111a, thereby improving heat dissipation efficiency for the first power assembly 11a.

Specifically, in the example provided in this application, the first circuit board assembly 113a includes a first circuit board 1131a and a plurality of (four shown in the figure) electronic components 1132a. The first circuit board 1131a has a first board surface 11311a and a second board surface 11312a, and the first board surface 11311a and the second board surface 11312a are two board surfaces, away from each other, of the first circuit board 1131a. The plurality of electronic components 1132a are all disposed on the first board surface 11311a, and are connected to the liquid cooling plate 112a in a thermally conductive manner through a material with good thermal conductivity such as thermally conductive silicone 13. The first board surface 11311a of the first circuit board 1131a is connected to the first housing 111a in a thermally conductive manner through a material with good thermal conductivity such as thermally conductive silicone 14.

In the example provided in this application, the electronic components 1132a are all disposed on the first board surface 11311a of the first circuit board 1131a. This helps improve manufacturing efficiency of the first circuit board assembly 113a during manufacturing. For example, the electronic components 1132a may be all disposed on the first board surface 11311a of the first circuit board 1131a by using a surface-mount technology or the like. Alternatively, it may be understood that, when the plurality of electronic components 1132a are separately disposed on the first board surface 11311a and the second board surface 11312a of the first circuit board 1131a, the first circuit board 1131a needs to be turned over, or an operation such as secondary welding needs to be performed. As a result, a manufacturing process and technology are added. This does not help improve manufacturing efficiency.

In addition, when the first power assembly 11a is assembled, the first board surface 11311a of the first circuit board 1131a may face the first liquid cooling plate 112a, thereby helping connect the plurality of electronic components 1132a to the first liquid cooling plate 112a in a thermally conductive manner.

In actual application, when there is a current flowing in the first circuit board 1131a, heat may be generated. Therefore, the first circuit board 1131a also has a heat dissipation requirement.

In the example provided in this application, because the second board surface 11312a of the first circuit board 1131a faces the first housing 111a, this helps connect the first circuit board 1131a to the first housing 111a in a thermally conductive manner.

It may be understood that, in actual application, heat generated by the electronic components 1132a is usually greater than heat generated by the first circuit board 1131a, and the heat dissipation efficiency of the first liquid cooling plate 112a is greater than the heat dissipation efficiency of the first housing 111a. Therefore, the first circuit board 1131a may be connected to the first housing 111a in a thermally conductive manner, so that the heat of the first circuit board 1131a can be dissipated by using the first housing 111a. The electronic component 1132a is connected to the first liquid cooling plate 112a in a thermally conductive manner, so that the heat of the electronic component 1132a can be dissipated by using the first liquid cooling plate 112a.

The first housing 111a may be made of a material with relatively good thermal conductivity, such as steel, copper, or aluminum, and mainly dissipates heat through heat transfer of the material. The first housing 111a has advantages of easy manufacturing, low costs, and high reliability. In addition, during manufacturing, it is also easy to prepare a structure with a complex shape.

The first liquid cooling plate 112a has a passage inside for circulation of the cooling medium. Therefore, in actual application, this does not facilitate manufacturing of a complex shape. The complex shape leads to problems such as low reliability and significantly increased costs.

Currently, as power of the charging device 10 continuously increases, a heat dissipation requirement of the first circuit board 1131a also continuously increases. In actual application, if the first housing 111a is changed to be in a liquid cooling structure (for example, a structure similar to a structure of the first liquid cooling plate 112a), costs of the charging device 10 are significantly increased. Alternatively, if the liquid cooling structure in the first liquid cooling plate 112a is extended into the first housing 111a, reconstruction costs of the cooling pipeline 1121a may also be increased, and a leakage risk of the cooling pipeline 1121a may also be increased.

In the example provided in this application, after the first power assembly 11a and the second power assembly 11b are stacked, heat dissipation effect for the first circuit board 1131a can be improved by using the elastic heat conducting member 12.

Specifically, the first liquid cooling plate 112a of the first power assembly 11a has a first contact surface 101a, and the first housing 111a has a second contact surface 102a. The second liquid cooling plate 112b of the second power assembly 11b has a first contact surface 101b, and the second housing 111b has a second contact surface 102b. The first contact surface 101b and the second contact surface 102a are disposed opposite to each other. The elastic heat conducting member 12 is located between the first contact surface 101b and the second contact surface 102a, and elastically abuts against the first contact surface 101b and the second contact surface 102a. After heat generated by the first circuit board 1131a is transferred to the first housing 111a, the heat may be transferred to the second liquid cooling plate 112b through the elastic heat conducting member 12. To be specific, the second liquid cooling plate 112b of the second power assembly 11b can dissipate heat for the first circuit board 1131a of the first power assembly 11a, thereby significantly improving the heat dissipation effect for the first circuit board 1131a.

It may also be understood that, in the example provided in this application, the first contact surface and the second contact surface of each power assembly are two surfaces that are disposed away from each other.

For example, in the first power assembly 11a, the first contact surface 101a is away from the second contact surface 102a. When the plurality of power assemblies are stacked, all the power assemblies may be sequentially stacked based on basically same spatial poses. Therefore, in two adjacent power assemblies, a first contact surface of one of the power assemblies and a second contact surface of the other one of the power assemblies may be disposed opposite to each other.

In specific application, the elastic heat conducting member 12 may be in various structural shapes.

For example, as shown in FIG. 2, in the example provided in this application, the elastic heat conducting member 12 is in a wave-shaped plate structure. Specifically, both a wave crest and a wave trough of the elastic heat conducting member 12 are arc surfaces.

In a natural state, a height difference between the wave crest and the wave trough of the elastic heat conducting member 12 is greater than a distance between the first contact surface 101b and the second contact surface 102a. After the elastic heat conducting member 12 is disposed between the first contact surface 101b and the second contact surface 102a, the elastic heat conducting member 12 is subject to a squeezing force of the first contact surface 101b and the second contact surface 102a, to elastically abut against the first contact surface 101b and the second contact surface 102a. In addition, after the elastic heat conducting member 12 is squeezed, elastic deformation may occur. In this case, a contact area between the elastic heat conducting member 12 and the first contact surface 101b may be increased, and a contact area between the elastic heat conducting member 12 and the second contact surface 102a may be increased. This helps ensure contact effect between the elastic heat conducting member 12 and each of the first contact surface 101b and the second contact surface 102a.

In addition, in the example provided in this application, a first air duct 121 is formed between the elastic heat conducting member 12 and the first contact surface 101b, and a second air duct 122 is formed between the elastic heat conducting member 12 and the second contact surface 102a. When there is air flowing through the first air duct 121, heat is taken away from the elastic heat conducting member 12 and the first contact surface 101b. Correspondingly, when there is air flowing through the second air duct 122, heat is taken away from the elastic heat conducting member 12 and the second contact surface 102a. This helps improve the heat dissipation efficiency of the charging device 10.

In actual application, a fan may be disposed in the charging device 10, to increase a flow speed of air flowing through the first air duct 121 or the second air duct 122.

In summary, after the elastic heat conducting member 12 is disposed in a wave shape, it can be ensured that the elastic heat conducting member 12 abuts against the first contact surface 101b and the second contact surface 102a; and the first air duct 121 can be formed between the elastic heat conducting member 12 and the first contact surface 101b, and the second air duct 122 can be formed between the elastic heat conducting member 12 and the second contact surface 102a, thereby improving heat dissipation performance of the charging device 10.

It may be understood that, in another example, the elastic heat conducting member 12 may be alternatively in another shape.

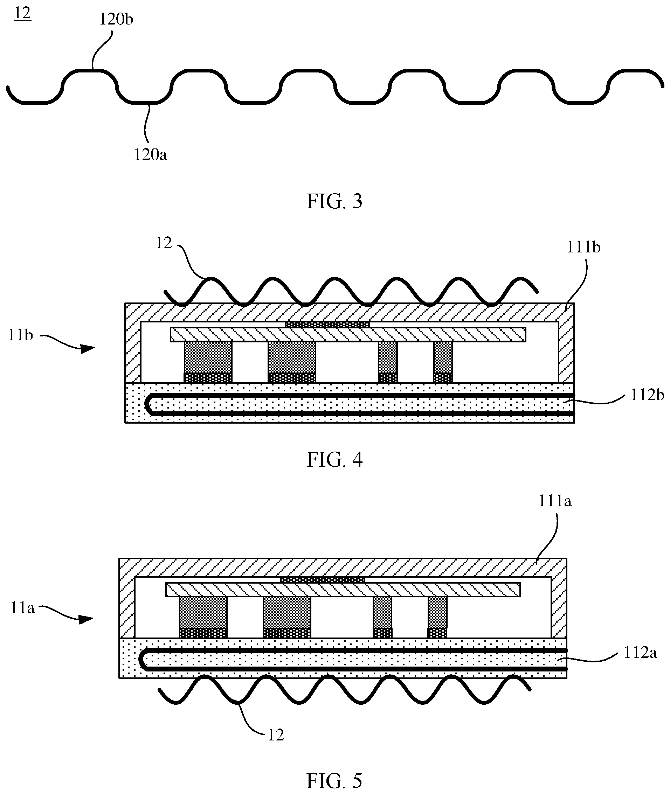

For example, with reference to FIG. 2 and FIG. 3, in another example provided in this application, with the first contact surface 101b, a surface, facing the first contact surface, of the elastic heat conducting member 12 has at least one third contact part 120a that abuts against the first contact surface, and the third contact part 120a is a plane. A surface, facing the second contact surface 102a, of the elastic heat conducting member 12 has at least one fourth contact part 120b that abuts against the second contact surface 102a, and the fourth contact surface 120b is also a plane. In the example provided in FIG. 3, a quantity of third contact parts 120a and a quantity of fourth contact parts 120b each are six. It may be understood that in another example, a quantity of third contact parts 120a and a quantity of fourth contact parts 120b each may be alternatively one, two, or more. This is not limited in this application.

Specifically, because the first contact surface 101b is a plane, after the third contact part 120a, abutting against the first contact surface 101b, of the elastic heat conducting member 12 is disposed as a plane, the contact area between the elastic heat conducting member 12 and the first contact surface 101b can be increased, thereby helping improve heat exchange efficiency between the elastic heat conducting member 12 and the first housing 111a. Correspondingly, because the second contact surface 102a is a plane, after the fourth contact surface 120b, abutting against the second contact surface 102a, of the elastic heat conducting member 12 is disposed as a plane, the contact area between the elastic heat conducting member 12 and the second contact surface 102a can be increased, thereby helping improve heat exchange efficiency between the elastic heat conducting member 12 and the first liquid cooling plate 112a.

Certainly, in actual application, the first contact surface 101b or the second contact surface 102a may be alternatively a curved surface, and a surface, in contact with the first contact surface 101b or the second contact surface 102a, of the elastic heat conducting member 12 may also be a curved surface. Details are not described herein.

In specific application, the elastic heat conducting member 12 may be made of a material with high thermal conductivity, such as copper, aluminum, and an alloy thereof.

Alternatively, the material of the elastic heat conducting member 12 includes a shape memory alloy. When a temperature of the elastic heat conducting member 12 rises, the elastic heat conducting member 12 tends to increase the contact area with the first contact surface 101b or the second contact surface 102a, thereby increasing the contact area between the elastic heat conducting member 12 and the first contact surface 101b or the second contact surface 102a.

Specifically, in actual application, the elastic heat conducting member 12 is in contact with the first contact surface 101b and the second contact surface 102a. Therefore, when a temperature of the first housing 111a is high, the temperature of the first housing 111a needs to be lowered efficiently. Therefore, after the high temperature of the first housing 111a is transferred to the elastic heat conducting member 12, a predetermined deformation occurs on the elastic heat conducting member 12. In addition, due to the deformation, the contact area between the elastic heat conducting member 12 and each of the first contact surface 101b and the second contact surface 102a can be increased, thereby improving the heat exchange efficiency between the first contact surface 101b and the second contact surface 102a.

For example, when the temperature is low, the shape of the elastic heat conducting member 12 may be similar to the shape shown in FIG. 2. When the temperature is high, the shape of the elastic heat conducting member 12 may be similar to the shape shown in FIG. 3.

Certainly, in another example, a relationship between the shape and the temperature of the elastic heat conducting member 12 may also be appropriately set according to different requirements. Details are not described herein.

In addition, in the another example, the elastic heat conducting member 12 may be alternatively in a structure such as a thermally conductive pad having an elastic compression characteristic. Details are not described herein.

In actual application, the elastic heat conducting member 12 may be an independent structural member, or may be a component of a power assembly.

For example, as shown in FIG. 4, the elastic heat conducting member 12 may be fastened to the first housing 111a.

Alternatively, as shown in FIG. 5, the elastic heat conducting member 12 may be fastened to the second liquid cooling plate 112b.

It may be understood that in the foregoing embodiment, specific description is provided by using an example in which the charging device 10 includes two power assemblies. In actual application, the charging device 10 may include three or more power assemblies.

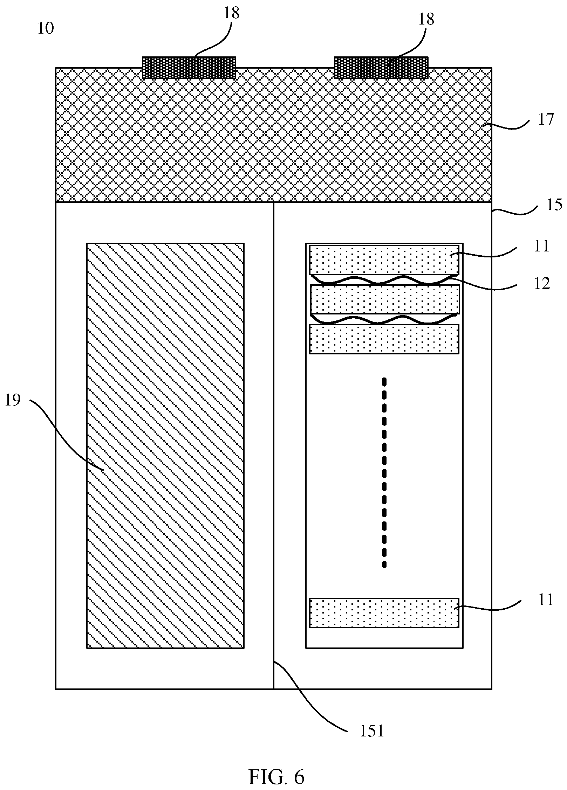

For example, as shown in FIG. 6, in an example provided in this application, the charging device 10 further includes a chassis 15, and a plurality of power assemblies 11 are sequentially stacked in the chassis 15.

During installation, after the power assemblies 11 are installed in place, the elastic heat conducting member 12 may be inserted into a gap between two adjacent power assemblies 11. Alternatively, the power assemblies 11 and the elastic heat conducting member 12 may be sequentially installed.

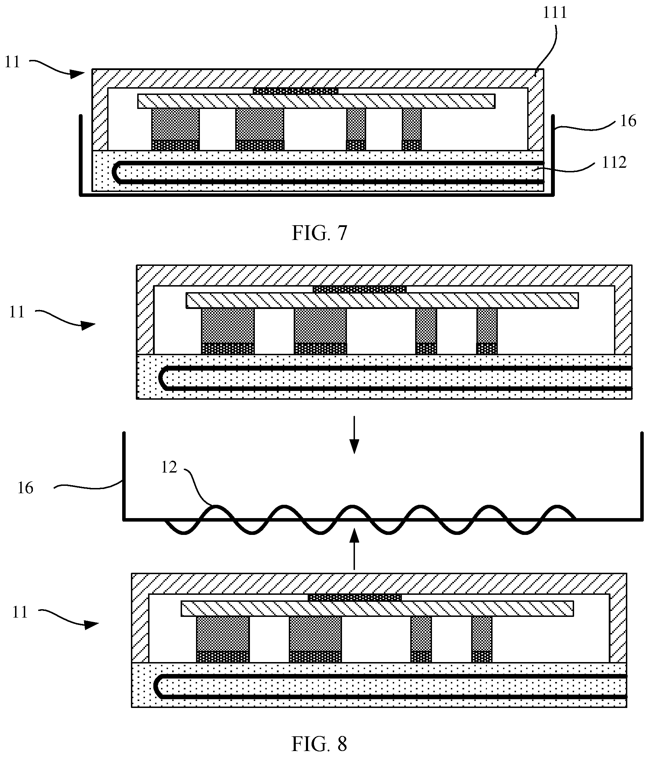

As shown in FIG. 7, in some examples, the chassis 15 may further include a drawer-type structure such as a tray 16, and the power assemblies 11 may be installed in the chassis 15 by using the structure such as the tray 16, to improve convenience during installation and maintenance. The tray 16 and the chassis 15 may be connected through a currently commonly used structure such as a slide. This is not limited in this application.

In addition, as shown in FIG. 8, in some examples, the elastic heat conducting member 12 may be fastened to the tray 16. Refer to FIG. 6 and FIG. 8 together. After the power assemblies 11 located on two sides of the tray 16 are installed in the box body 15, the power assemblies 11 can be in contact with the elastic heat conducting member 12 in a thermally conductive manner, thereby implementing high installation convenience.

In addition, as shown in FIG. 6, in an example provided in this application, the charging device 10 further includes a radiator 17. The radiator 17 may be connected to the liquid cooling plate in the power assembly 11 through a pipeline. The cooling medium may circulate between the radiator 17 and the liquid cooling plate, so that the radiator 17 can lower a temperature of the liquid cooling plate.

During specific disposition, the fan 17 may be disposed on the top of the radiator 17, and is configured to accelerate a flow speed of air flowing through the radiator 17, thereby improving heat dissipation efficiency of the radiator 17.

In addition, in the example provided in this application, the chassis 15 further has a separator 151, and the separator 151 separates internal space of the chassis 15 into a power distribution area and an area for installing the power assemblies 11. A power distribution device 19 may be disposed in the power distribution area. When the power distribution device 19 is disposed, the power distribution device 19 may include a currently commonly used circuit breaker, overload protection circuit, and the like. The power distribution device 19 may be installed on an inner wall of the chassis 15, or the power distribution device 19 may be integrated into a cabinet. This is not limited in this application.

It may be understood that, in specific application, types and a quantity of components included in the power distribution device 19 may be flexibly adjusted according to an actual requirement. This is not limited in this application.

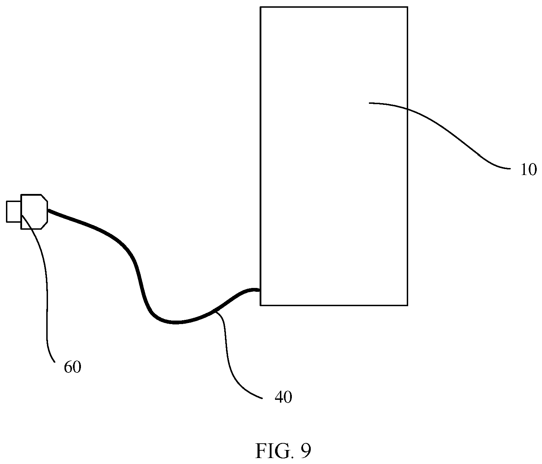

In addition, as shown in FIG. 9, an embodiment of this application further provides a charging system, including a charging terminal 60 and a charging device 10. The charging terminal 60 is connected to an output end of the charging device 10 through a cable. In specific application, the charging device 10 may perform processing such as frequency conversion on an alternating current in a power grid, or may convert an alternating current into a direct current and then provide the direct current to the charging terminal 60. The charging terminal 60 may be connected to a powered device (for example, a vehicle), to supplement electric energy to the powered device. The charging terminal 60 may be in a form of a charging connector or the like. In addition, one charging device 10 may be connected to one charging terminal 60, or may be connected to a plurality of charging terminals 60. A quantity of charging terminals 60 is not limited in this application.

During specific disposition, the charging device 10 may be installed on the ground, or may be installed at a position such as a wall. A specific installation position and a form of the charging device 10 are not limited in this application.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

In this application, "at least one" means one or more, and "a plurality of" means two or more. "And/or" describes an association relationship between associated objects and indicates that three relationships may exist. For example, A and/or B may indicate the following three cases: Only A exists, both A and B exist, and only B exists, where A and B each may be singular or plural.

It may be understood that various numbers in embodiments of this application are merely used for differentiation for ease of description, and are not used to limit the scope of embodiments of this application. Sequence numbers of the foregoing processes do not mean an execution sequence. The execution sequence of the processes should be determined based on functions and internal logic of the processes.

## Claims

1. A charging device, comprising an elastic heat conducting member and at least two stacked power assemblies, wherein
the power assembly comprises a housing, a liquid cooling plate, and a circuit board assembly, the housing and the liquid cooling plate form an accommodating cavity, and the circuit board assembly is disposed in the accommodating cavity and is connected to both the housing and the liquid cooling plate in a thermally conductive manner;
the liquid cooling plate of each power assembly has a first contact surface, the housing has a second contact surface, and the first contact surface is away from the second contact surface; and
in the two adjacent power assemblies, the first contact surface of one of the power assemblies and the second contact surface of the other one of the power assemblies are disposed opposite to each other, and the elastic heat conducting member is located between the first contact surface and the second contact surface, and separately elastically abuts against the first contact surface and the second contact surface.

2. The charging device according to claim 1, wherein the elastic heat conducting member is a wave-shaped sheet.

3. The charging device according to claim 1 or 2, wherein a first air duct exists between the elastic heat conducting member and the first contact surface, and a second air duct exists between the elastic heat conducting member and the second contact surface.

4. The charging device according to any one of claims 1 to 3, wherein a surface, facing the first contact surface, of the elastic heat conducting member has at least one third contact part that abuts against the first contact surface, and the third contact part is a plane.

5. The charging device according to any one of claims 1 to 4, wherein a surface, facing the second contact surface, of the elastic heat conducting member has at least one fourth contact part that abuts against the second contact surface, and the fourth contact part is a plane.

6. The charging device according to any one of claims 1 to 5, wherein a material of the elastic heat conducting member comprises a shape memory alloy; and
the elastic heat conducting member is configured to: when a temperature rises, tend to increase a contact area with the first contact surface or the second contact surface.

7. The charging device according to any one of claims 1 to 6, wherein the circuit board assembly comprises a circuit board and an electronic component;
the circuit board comprises a first board surface and a second board surface that are away from each other, and the electronic component is located on the first board surface; and
the electronic component is connected to the liquid cooling plate in a thermally conductive manner, and the second board surface is connected to the housing in a thermally conductive manner.

8. The charging device according to any one of claims 1 to 7, further comprising a chassis, wherein the power assemblies are installed in the chassis; and
the elastic heat conducting member is detachably installed in the chassis.

9. The charging device according to any one of claims 1 to 8, wherein the elastic heat conducting member is fastened to the housing or the liquid cooling plate.

10. The charging device according to any one of claims 1 to 8, wherein the charging device comprises a tray, and the elastic heat conducting member is fastened to the tray.

11. The charging device according to any one of claims 1 to 10, further comprising a radiator, wherein the radiator is connected to the liquid cooling plate through a liquid cooling pipeline.

12. A charging system, comprising a charging terminal and the charging device according to any one of claims 1 to 11, wherein the charging device has an output port, and the charging terminal is connected to the output port.
